# EUROPÄISCHE PATENTANMELDUNG

(11) **EP 1 235 467 A2**
(43) Veröffentlichungstag der Anmeldung: **28.08.2002**
(21) Anmeldenummer: 02090076.7
(22) Anmeldetag: 27.02.2002
(51) Int. Cl.: H05B 33/14, C09K 11/06, H01L 51/20

(54) **Elektrolumineszierende Vorrichtung, neue lumineszierende Verbindungen und Dotierstoffe**

(30) Priorität: 27.02.2001 DE 10109465
(71) Anmelder: Syntec Gesellschaft für Chemie und Technologie der Informationsaufzeichnung mbH, 06766 Wolfen (DE)
(72) Erfinder: Richter, Andreas Dr., 06188 Plössnitz (DE); Keil, Dietmar, 06766 Wolfen (DE); Diener, Gerhard Dr., 06366 Köthen (DE)
(74) Vertreter: Walter, Wolf-Jürgen

(57) **Zusammenfassung**

Die Erfindung betrifft eine elektrolumineszierende Vorrichtung, bei der die lumineszierende Schicht eine lumineszierende Verbindung und eine Verbindung der allgemeinen Formel I als Dotierstoff enthält, wobei B ein ungesättigter carbocyclischer oder heterocyclischer 4-8-gliedriger Ring ist, der auch eine alicyclische Brücke aufweisen kann, die Ringe D und E sind fünf- oder sechsgliedrige Ringe, die jeweils ein weiteres Heteroatom N, O, S enthalten können; die Reste R sind ein oder mehrere Substituenten H oder geradkettiges oder verzweigtes C₁-C₆-Alkyl ; X und Y sind Kohlenstoff oder Stickstoff; R₁, R₂ und R₉ sind H oder geradkettiges oder verzweigtes C₁-C₆-Alkyl; R₃ und R₈ sind Wasserstoff, geradkettiges oder verzweigtes C₁-C₆-Alkyl, Hydroxy, -OR₁₆, -COOR₁₆, N,N-Dialkylamino, Acetylamino oder Halogen, wobei R₁₆ Wasserstoff, oder geradkettiges oder verzweigtes C₁-C₆-Alkyl ist; R₁ und R₂ oder R₂ und R₃ und/oder R₈ und R₉ können zusammen einen alicyclischen, heterocyclischen oder aromatischen Ring bilden; und A₁ und A₂, gleich oder verschieden, sind Cyan, Nitro oder -COOR₁₆. Die Verbindungen I sind teilweise neu. Die Dotierstoffe leuchten zusammen mit der lumineszierenden Verbindung konzentrationsabhängig rot oder weiß mit sehr guter Quanteneffizienz.

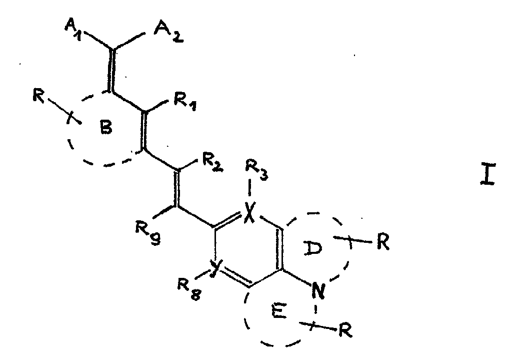

## Beschreibung

Die Erfindung betrifft eine organische insbesondere rot elektrolumineszierende Vorrichtung, speziell eine Vorrichtung mit einer lumineszierenden Schicht, enthaltend mindestens eine lumineszierende Verbindung oder zusätzlich einen neuen Dotierstoff dafür; sowie neue Verbindungen.

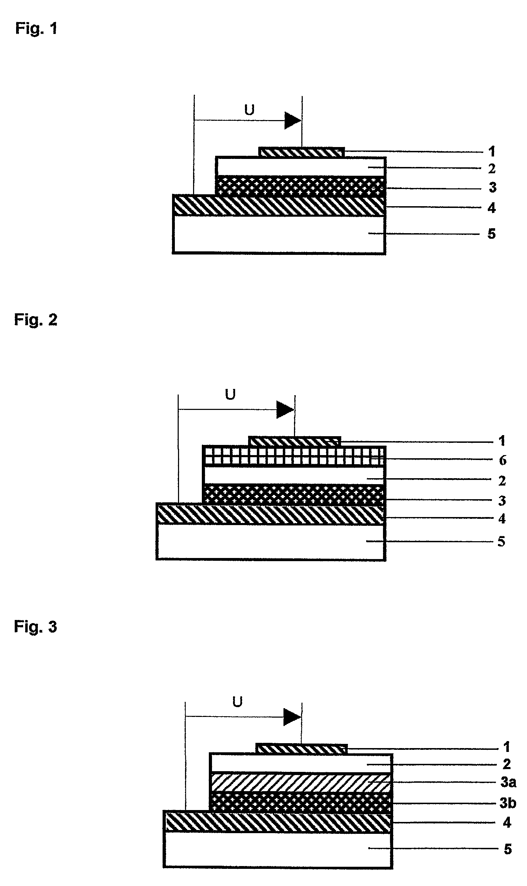

Organische elektrolumineszierende Vorrichtungen sind seit längerer Zeit bekannt und bestehen im einfachsten Falle aus einem Glassubstrat mit einer transparenten Indium-Zinn-Oxid-Beschichtung (ITO), einer Löcher-Transportschicht, gefolgt von einer lumineszierenden Schicht sowie einer Metallelektrode mit niedriger Elektronenaustrittsarbeit (siehe Fig. 1).

Dabei werden in Durchgangsrichtung von der Metallelektrode (Kathode), meist aus Ca oder Mg, durch Co- oder nacheinanderfolgender Verdampfung zum Beispiel mit Al oder Ag hergestellt, Elektronen und vom transparenten ITO-Kontakt (Anode) Löcher (Defektelektronen) in den organischen Schichtverband injiziert. Diese rekombinieren dort und bilden Singulett-Excitonen, die nach kurzer Zeit unter Emission von Licht in den Grundzustand übergehen. Der organische Schichtverband besteht hier aus einer lumineszierenden Schicht (lumineszierende Verbindung ist auch gleichzeitig Elektronenleiter) und einer Löcher-Transportschicht. In der Löcher-Transportschicht werden als Löcher-Transportmaterialien bevorzugt N,N'-Biphenyl-N,N'-bis-(m-tolyl)-benzidin (TPD) und N,N'-Biphenyl-N,N'-bis-(1-naphthyl)-benzidin (1-NPB) eingesetzt. Die zusätzliche Anlagerung einer Elektronen-Transportschicht führt häufig zu einer Erhöhung der Quantenausbeute und oder einer Reduzierung der Einsetzspannung der elektrolumineszierenden Vorrichtung (siehe Fig. 2).

Gleichzeitig kann nun die lumineszierende Schicht sehr dünn ausgeführt werden. Durch die Verwendung von lumineszierenden Material unabhängig von seinen Transporteigenschaften kann die Emissionswellenlänge gezielt im gesamten sichtbaren Spektralbereich eingestellt werden.

Weiterhin erhält man eine Verbesserung der Eigenschaften der elektrolumineszierenden Vorrichtung (Erhöhung der Quantenausbeute und Erniedrigung der Elektrolumineszenz-Einsetzspannung), wenn mindestens zwei aufeinander abgestimmte Löcher-Transportschichten verwendet werden (siehe Fig. 3).

In manchen Fällen kann auch zusätzlich zwischen der lumineszierenden Schicht und der Metallelektrode eine Elektronen-Transportschicht (wie in Fig. 2) aufgebracht werden.

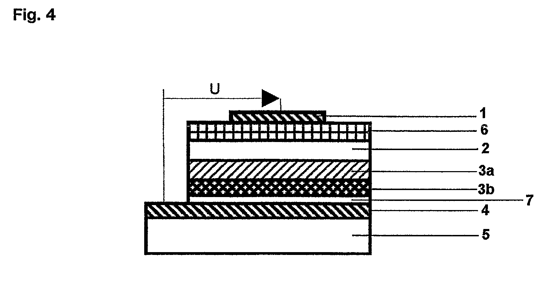

In neuerer Zeit wurde auch zur Verbesserung der Eigenschaften elektrolumineszierender Vorrichtungen eine zusätzliche dünne Löcher-Injektionsschicht aus zum Beispiel CuPC (Kupferphthalocyanin) zwischen dem transparenten ITO und der Löchertransportschicht aufgedampft (siehe Fig. 4).

Insbesondere verwendet man wegen ihres geringen lonisationspotentials in der zweiten Löcher-Transportschicht sog. "Starburst-Moleküle". Das sind hochmolekulare organische Verbindungen auf Basis von Triphenylamin-Einheiten.

Kürzlich wurde in der DE-A-19,541,113 ein neues Löcher-Transportmaterial offengelegt, das neben guten Löcher-Transporteigenschaften auch exzellente schichtbildende Eigenschaften, eine hohe thermische Stabilität und dadurch eine geringe Neigung zur Rekristallisation besitzt.

Für die Herstellung von full-color-tüchtigen elektrolumineszierenden Vorrichtungen ist es notwendig rot, grün und blau elektrolumineszierende Materialien mit hoher Elektrolumineszenz-Quantenausbeute und Farbreinheit zu verwenden.

Seit langer Zeit wird in der lumineszierenden Schicht als bevorzugtes Leuchtmaterial Tris-(8-hydroxychinolino)-aluminium (AlQ)₃ eingesetzt (C.W. Tang, S.A. van Slyke: Appl. Phys. Lett. **51,** 1987, 913). Dieser Metallchelatkomplex luminesziert im Schichtverband selbst grün, wobei als Metalle im Komplex auch Beryllium oder Gallium eingesetzt werden können.

Blau elektrolumineszierende Vorrichtungen erhält man durch Verwendung von Derivaten des 1,3,4-Oxadiazols oder durch Verwendung von Distyryl-arylenen. Rote Lumineszenzstrahlung wird insbesondere durch die Dotierung von AlQ₃ mit 2-alkyl-6-N,N-dialkylaminstyryl-substituierten 4-Dicyanomethylen-4H-pyranen, insbesondere aber mit dem 2-Methyl-6-(4-N,N-dimethylaminostyryl)-4-dicyanomethylen-4H-pyran (DCM) (US-A- 4,769,292), aber auch mit Quadratsäurefarbstoffen, erzielt.

Als nachteilig bei der Verwendung von DCM als Dotierstoff von AlQ₃ gilt es zu nennen, daß das emittierte Licht für das menschliche Auge zu orange erscheint, die Effizienz des emittierten Lichts für viele Anwendungen aufgrund von Aggregationseffekten des DCM-Farbstoffs im AlQ₃ nicht ausreichend hoch ist, und die damit gefertigten Leuchtdioden außerdem nicht langzeitstabil genug arbeiten.

Das bereits als Laserfarbstoff bekannt gewordene DCM (US-A-3,852,683) und weitere entsprechend daraus abgeleitete Farbstoffe stellen formal konjugiert polyenische Verbindungen mit einem Donator/Akzeptor-Substituentenmuster dar. Durch Variation der Donatorsubstituenten im Farbstoffmolekül, wie zum Beispiel durch den Austausch des 4-N,N-Dimethylaminophenyl-Rests im DCM durch den wesentlich donatorstärkeren Julolidin-Rest (Farbstoff DCJ), verschieben sich die langwellige Absorptionsbande und parallel dazu auch die Emissionsbande bathochrom gegenüber dem DCM. Bei Verwendung von DCJ in elektrolumineszierenden Vorrichtungen entspricht der visuelle Farbeindruck dann auch einem intensiveren Rot.

Die nachteilige Aggregationstendenz im Anwendungsbereich des Dotierstoffs >1 Gew.% bezogen auf AlQ₃ bleibt aber auch hier bestehen, so daß diese Materialien in elektrolumineszierenden Vorrichtungen zu wenig Effizienz erzeugen. Außerdem sei bei der Verwendung von DCJ auf die schlechte Verdampfbarkeit der Verbindung hingewiesen. Die hohe Zersetzungsrate während des Verdampfungsprozesses führt vor allem zu Problemen bei der Herstellung der lumineszierenden Schicht an sich.

Das Einbringen von sperrigen tert.-butyl-Substituenten in die 2-Position des Pyranrings entsprechender DCM-analoger Farbstoffe, wie in der US-A-5,935,720 genannt, verringert zwar die Aggregationtendenz zum Beispiel der Farbstoffe DCJT und DCJTB gegenüber dem DCJ oder DCM, wobei aber auch diese nicht ausreichend genug unterdrückt werden kann, um Materialien für full-color-taugliche Anwendungen zu Verfügung zu stellen.

Nachteilig bei all den bisher bekannten Dotierstoff / AlQ₃ Systemen ist neben den bereits genannten Effekten der visuell unreine Farbeindruck (Farbton) des emittierten Lichts, der häufig nur als ein stumpfes Orangerot bis Rot vom menschlichen Auge wahrgenommen wird. Gründe dafür sind offenbar das Vorhandensein von jeweils zwei Konjugationsrichtungen, die für diese Farbstoffklasse charakteristisch sind. Zum einen führt die Hauptkonjugationsrichtung dieser "D/A-Farbstoffe" vom Donatorsubstituent D über die polyenische Kette hin zum Akzeptor A (hier eine Cyano-Gruppe) in der 4-Position des Pyranrings und zum anderen über eine kurze Konjugationskette von einem positiv mesomeren Substituenten in der 2-Position am Pyranring (kann ein Phenyl- oder substituierter Phenyl-Ring sein) bzw. von einem positiv induktiven Substituenten an gleicher Position (kann eine Alkyl- oder verzweigte Alkylgruppe sein) ebenfalls hin zum Akzeptorsubstituenten in der 4-Position des Pyranrings. Diese quasi gekreuzte Konjugation liefert breite Absorptions- und Emissionsbanden und damit unreine Farbtöne des emittierten Lichts.

Kürzlich wurde von X.T.Tao, S. Miyata, H. Sasabe, G.J. Zhang, T. Wada, M.H.Jiang (Appl. Physics Letters **78**, 2001, 279 - 281) gezeigt, daß durch Verwendung von 3-(Dicyanomethylen)-5,5-dimethyl-1-(4-N,N-dimethylamino-styryl)-cyclohexen (DCDDC) als Dotierstoff von AlQ₃ an Stelle der Farbstoffe auf DCM-Basis in der elektrolumineszeierenden Schicht wesentlich reinere und intensivere Licht-Emissionen erzielt werden. Aufgrund nur einer möglichen Konjugationsrichtung in diesem Farbstofftyp sind die Absorptions- und Emissionsbanden sehr schmal. Die genannten Materialien erreichen allerdings bei einer 1%-igen Dotierung von AlQ₃ bereits ihr maximale Elektrolumineszenz-Quantenausbeute, da höhere Dotierungen, bezogen auf AlQ₃, auch hier verstärkt zur Bildung von Aggregaten führen.

Die bei diesen Systemen optimale Konzentration des Dotierstoffs im Bereich < 1 Gew.%, bezogen auf AlQ₃, ist zu niedrig, so daß infolge unzureichender Energieübertragung die Eigenlumineszenz von AlQ₃ den Farbeindruck des resultierenden emittierten Lichts verfälscht. Unreine rote Farbtöne sind wiederum die Folge, so daß der zunächst offenbarte Vorteil dieser Farbstoffe gegenüber den DCM-Typen dadurch weitestgehend verlorengeht.

Aufgabe der Erfindung war es, eine organische elektrolumineszierende Vorrichtung mit verbesserter Quanteneffizienz und verbesserter Langzeitstabilität bereitzustellen und dabei für die lumineszierende Schicht neue lumineszierende Verbindungen und neue Dotierstoffe für bekannte lumineszierende Verbindungen, insbesondere für AlQ₃, zu entwickeln. Eine weitere Aufgabe war die Bereitstellung neuer Verbindungen.

Erfindungsgemäß besteht die elektrolumineszierende Vorrichtung wenigstens aus einer Löcher-Transportschicht und einer lumineszierenden Schicht zwischen zwei leitfähigen Elektroden, wobei wenigstens eine Elektrode transparent ist, und sie ist dadurch gekennzeichnet, daß
die lumineszierende Schicht als lumineszierende Verbindung oder als Dotierstoff für eine lumineszierende Verbindung wenigstens eine Verbindung der allgemeinen Formel I enthält 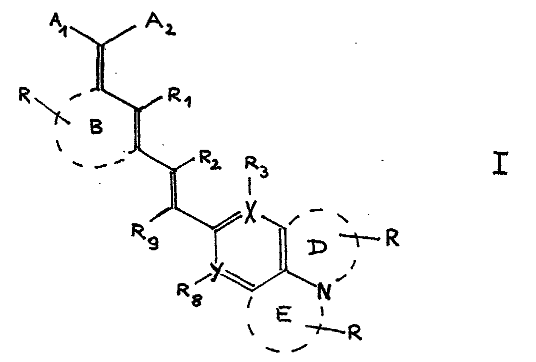 worin
B ein ungesättigter carbocyclischer oder heterocyclischer 4-8-gliedriger Ring mit O, N oder S als Heteroatom ist, wobei im Falle eines 6-8-gliedrigen Ringes zwei C-Atome in diesem Ring verbrückt sein können, d.h. sie können eine Brücke bilden;
die Ringe D und E sind fünf- oder sechsgliedrige Ringe, die jeweils ein weiteres Heteroatom enthalten können, ausgewählt unter N, O und S;
die Reste R sind ein oder mehrere Substituenten, die gleich oder verschieden sein können und Wasserstoff oder geradkettiges oder verzweigtes C₁-C₆-Alkyl sind;
X und Y sind Kohlenstoff oder Stickstoff;
R₁, R₂ und R₉ sind gleich oder verschieden und sind Wasserstoff oder geradkettiges oder verzweigtes C₁-C₆-Alkyl;
R₃ und R₈ sind gleich oder verschieden und sind Wasserstoff, geradkettiges oder verzweigtes C₁-C₆-Alkyl, Hydroxy, -OR₁₆, -COOR₁₆, N,N-Dialkylamino, Acetylamino oder Halogen, wobei R₁₆ Wasserstoff, oder geradkettiges oder verzweigtes C₁-C₆-Alkyl ist,
R₁ und R₂ oder R₂ und R₃ und/oder R₈ und R₉ können zusammen einen alicyclischen, heterocyclischen oder aromatischen Ring bilden; und
A₁ und A₂, die gleich oder verschieden sein können, sind Cyan, Nitro oder -COO R₁₆, worin R₁₆ die oben genannte Bedeutung hat.

Eine besondere Ausführungsform der Erfindung betrifft elektrolumineszierende Vorrichtungen, die als Dotierstoff, allein oder im Gemisch mit anderen Dotierstoffen, eine Verbindung der allgemeinen Formel II enthalten 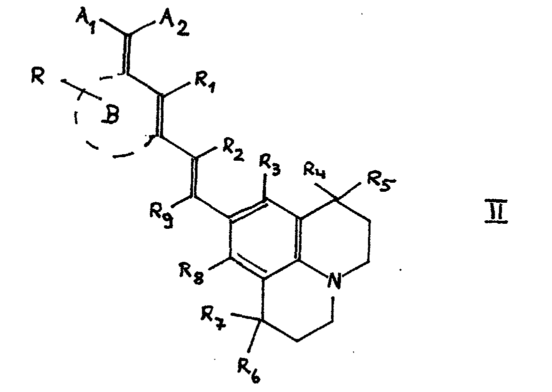 worin R₁, R₂, R₄ bis R₇ und R₉ gleich oder verschieden sind und Wasserstoff, oder geradkettiges oder verzweigtes C₁-C₆-Alkyl darstellen,
R₃ und R₈ sind gleich oder verschieden und sind Wasserstoff, geradkettiges oder verzweigtes C₁-C₆-Alkyl, Hydroxy, -OR₁₆, -COOR₁₆, N,N-Dialkylamino, Acetylamino oder Halogen, wobei R₁₆ Wasserstoff oder geradkettiges oder verzweigtes C₁-C₆-Alkyl ist,
R₁ und R₂ oder R₂ und R₃ und/oder R₈ und R₉ können zusammen einen alicyclischen, heterocyclischen oder aromatischen Ring bilden,
B ist ein fünf- oder sechsgliedriger ungesättigter Ring, bei dem im Falle eines sechsgliedrigen Ringes zwei Ringatome in 1,3-Stellung zueinander eine alicyclische Brücke bilden können, und die Reste R sind ein oder mehrere Substituenten, die gleich oder verschieden sein können und Wasserstoff oder geradkettiges oder verzweigtes C₁-C₆-Alkyl sind;
A₁ und A₂, die gleich oder verschieden sein können, sind Cyan, Nitro oder -COOR₁₆, wobei R₁₆ Wasserstoff oder geradkettiges oder verzweigtes C₁-C₆-Alkyl ist.

Bevorzugte Reste R bis R₉ ihrer Bedeutung als Niederalkylreste (C1-C6) sind solche, die jeweils Methyl, Isopropyl oder tert-Butyl darstellen.

Eine weitere bevorzugte Ausführungsform betrifft eine Vorrichtung, in der als Dotierstoff eine Verbindung der allgemeinen Formel III oder der allgemeinen Formel IV enthalten ist 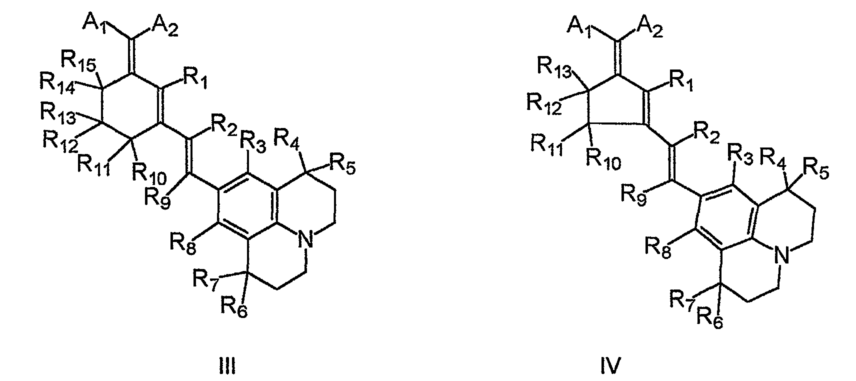 , worin R₁₀ bis R₁₅ Wasserstoff oder geradkettiges oder verzweigtes C₁-C₆-Alkyl sind, vorzugsweise Methyl, und die anderen Reste die zuvor genannte Bedeutung haben. Dabei können R₁₀ und R₁₅ gegebenenfalls eine alicyclische Brücke bilden, wie z.B im Farbstoff 2 oder 4, siehe Tabelle I weiter unten.

Die organische elektrolumineszierende Vorrichtung besteht im einfachsten Fall aus einem Schichtverband entsprechend der Fig. **1**, aufgebaut aus einer Metallelektrode **1** (Kathode), einer lumineszierenden Schicht **2**, welche neben einer organischen lumineszierenden Verbindung, die insbesondere AlQ₃ ist, mindestens einen organischen Dotierstoff enthält, aus einer Löcher-Transportschicht **3**, welche eine organische Löcher-Transportverbindung enthält, einer transparenten leitfähigen Anode **4**, sowie einem Träger **5** aus Glas oder einem ähnlichen transparenten Material. Durch einen andersartigen Aufbau der elektrolumineszierenden Vorrichtung, wie zum Beispiel nach Fig. 2 mit einer zusätzlichen Elektronen-Transportschicht 6 und nach Fig. 3 mit zwei Löcher-Transportschichten 3a und 3b, können die Eigenschaften dieser Vorrichtung optimiert werden. Eine weitere Schicht ist möglich, wie z.B. eine dünne CuPC-Schicht zwischen der leitfähigen transparenten Schicht 4 und der Löcher-Transportschicht 3.

Vorteilhaft liegt die Verbindung der Formel I oder der Formel II auch als Dotierstoff im Gemisch mit anderen Dotierstoffen vor, die ausgewählt werden können aus der Gruppe, bestehend aus 2-Alkyl-6-N,N-dialkylaminostyryl- oder Julolidin-substitituierten 4-Dicyanomethylen-4-H-pyranen, entsprechenden mit tert-Butyl am Pyranring substituierten Pyranen und 3-(Dicyanomethylen)-5,5-dimethyl-1-(4-N,N-dimethylamino-styryl)cyclohexan, insbesondere mit einem 1,2- oder 1-3-substituierten Quadratsäure-Farbstoff. Die gemeinsame Verwendung von mehreren Dotierstoffen kann z.B. durch Co-verdampfung erfolgen.

Die organische lumineszierende Verbindung wird vorzugsweise ausgewählt unter Tris-(8-hydoxychinolino)-aluminium (AlQ₃), Derivaten des 1,3,4-Oxadiazols und Distyryl-aryl-Derivaten, wobei (AlQ₃)besonders bevorzugt ist.

Es wurde gefunden, daß die neu in elektrolumineszierenden Vorrichtungen eingesetzten neuen und bekannten Verbindungen im Konzentrationsbereich >1 Gew-% bis 8 Gew-%, vorzugsweise >1 bis 5 Gew-%, insbesondere 1,5-3 Gew-%, bezogen auf das Gewicht der organischen lumineszierenden Verbindung AlQ₃, ein sehr effizientes reines rotes Licht allein oder zusammen mit AlQ₃ erzeugen mit Leuchtdichten im Bereich von 570 bis 2100 cd/m² bei 10 bis 14 V, insbesondere 580 bis 2050 cd/m² bei 10,2 bis 13,8 V. Dies erfolgt ohne Nebenemission des AlQ₃ im Bereich um 530 nm.

Der erhöhte Konzentrationsbereich bei Dotierstoffen gegenüber bekannten elektrolumineszierenden Vorrichtungen führt zu einem qualitativ deutlich besseren Licht, bei dem die Eigenlumineszenz der lumineszierenden Verbindung, z.B. AlQ₃, den roten Farbton nicht verfälscht.

Es wurde weiterhin überraschend gefunden, daß die organische elektrolumineszierende Vorrichtung im Falle einer "Unterdotierung" einer lumineszierenden Verbindung, insbesondere bei einer Unterdotierung von AlQ₃, mit den erfindungsgemäß zu verwendenden Dotierstoffen weißes Licht emittiert. Eine Unterdotierung liegt dann vor, wenn man den Dotierstoff allein oder im Gemisch mit andersartigen Dotierstoffen in einer Konzentration zwischen 0,1 Gew.% und 0,8 Gew.%, insbesondere zwischen 0,1 Gew.% und 0,5 Gew.%, bezogen auf das Gewicht von AlQ₃, einsetzt, z.B. indem man beide co-verdampft.

Ohne Zwischenbelüftung dampft man schließlich die Metall-Kathode **1** durch Verdampfung von LiF oder Li-Benzoat und Al, meist im Verhältnis von 10:1 (0,7 nm Li-Benzoat + 100 nm Al) auf. Es können aber auch andere Metalle, wie Silber, Magnesium, Calcium oder Indium oder Legierungen hieraus oder andere Verhältnisse der Metalle oder Legierungen verwendet werden.

Gegenstand der Erfindung sind auch neue Verbindungen der allgemeinen Formel I 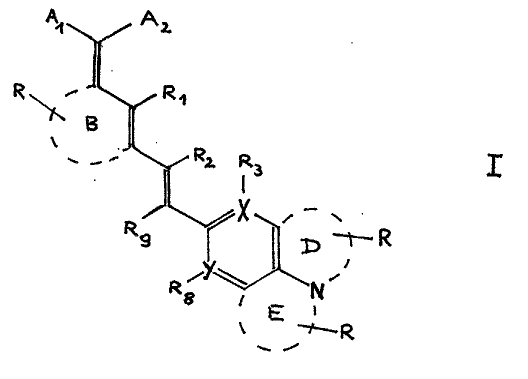 worin B ein 4-, 5-, 7-, oder 8 gliedriger ungesättigter carbocyclischer Ring ist, der durch Wasserstoff und/oder C₁-C₆-Alkyl substituiert ist und im Falle eines 5-gliedrigen Ringes wenigstens einen C₁-C₆-Alkylrest trägt; oder
B ist ein gegebenenfalls durch eine oder mehrere geradkettige oder verzweigte C₁-C₆-Alkylgruppen substituierter 6-gliedriger ungesättigter carbocyclischer Ring, bei dem zwei Ringatome in 1,3-Stellung zueinander eine alicyclische Brücke bilden können; oder
B ist ein 6- gliedriger ungesättigter carbocyclischer Ring, der durch eine oder mehrere C₁-C₆-Alkylgruppen substituiert ist; oder
B ist ein ungesättigter heterocyclischer 4- bis 8-gliedriger Ring mit O, N oder S als Heteroatom, der durch Wasserstoff und/oder eine oder mehrere C₁-C₆-Alkylgruppen substituiert ist;
und
die Ringe D und E sind fünf- oder sechsgliedrige Ringe, die jeweils ein weiteres Heteroatom enthalten können, ausgewählt unter N, O und S, mit der Maßgabe, daß wenigstens einer der beiden Ringe ein weiteres Heteroatom enthält; und
die Reste R sind ein oder mehrere Substituenten, die gleich oder verschieden sein können und Wasserstoff oder geradkettiges oder verzweigtes C₁-C₆-Alkyl sind;
X und Y können Kohlenstoff oder Stickstoff sein;
R₁, R₂ und R₉ sind gleich oder verschieden und sind Wasserstoff oder geradkettiges oder verzweigtes C₁-C₆-Alkyl;
R₃ und R₈ sind gleich oder verschieden und sind Wasserstoff, geradkettiges oder verzweigtes C₁-C₆-Alkyl, Hydroxy, -OR₁₆,
-COOR₁₆, N,N-Dialkylamino, Acetylamino oder Halogen, wobei R₁₆ Wasserstoff, oder geradkettiges oder verzweigtes C₁-C₆-Alkyl ist,
R₁ und R₂ oder R₂ und R₃ und/oder R₈ und R₉ können zusammen einen alicyclischen, heterocyclischen oder aromatischen Ring bilden; und
A₁ und A₂, die gleich oder verschieden sein können, sind Cyan, Nitro oder -COOR₁₆, wobei R₁₆ Wasserstoff, oder geradkettiges oder verzweigtes C₁-C₆-Alkyl ist.

Eine besondere Ausführungsform der Erfindung stellen Verbindungen der allgemeinen Formel I dar, worin
B ein 5-gliedriger ungesättigter carbocyclischer Ring ist und die Ringe D und E sechsgliedrige carbocyclische Ringe sind, die durch C₁-C₆-Alkylgruppen substituiert sind; oder worin
B ein gegebenenfalls durch eine oder mehrere geradkettige oder verzweigte C₁-C₆-Alkylgruppen substituierter sechsgliedriger ungesättigter carbocyclischer Ring ist,
bei dem zwei Ringatome in 1,3-Stellung zueinander eine alicyclische Brücke mit der Struktur 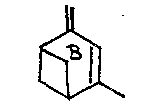 bilden können, und die Ringe D und E sechsgliedrige carbocyclische Ringe sind, die durch Wasserstoff und/oder C₁-C₆-Alkylgruppen substituiert sind, und worin X und Y Kohlenstoff darstellen.

Bevorzugte Reste R bis R₉ in der Bedeutung C₁-C₆-Alkyl sind Methyl, Isopropyl oder tert-Butyl.

Die Herstellung der elektrolumineszierenden Vorrichtung erfolgt allgemein in der Weise, daß man zunächst den als lumineszierende Verbindung, insbesondere aber als Dotierstoff anzuwendenden Farbstoff herstellt, indem man diesen beispielsweise aus Isophoron, Verbenon oder einem anderen cyclischen 1-Methyl-vinylketon mit Malonitril und entsprechendem 9-Formyljulolidin unter Wirkung eines Knoevenagel-Katalysators in einem aprotisch dipolaren Lösungsmittel, wie zum Beispiel in DMF, gegebenenfalls ohne Abtrennung gebildeter Zwischenprodukte herstellt, ihn isoliert, durch Umkristallisation vorreinigt und ihn durch Sublimation im Hochvakuum schließlich reinst erhält. Dann bringt man beispielsweise diesen Farbstoff als lumineszierende Verbindung oder als Dotierstoff einer lumineszierenden Verbindung, gegebenenfalls im Gemisch mit weiteren andersartigen Dotierstoffen, auf einen mit einer oder mehreren Löcher-Transportschichten bedampften leitfähigen transparenten (ITO) Träger auf, oder man bringt ihn auf einen durch Spin-Coating mit einer oder mehreren Löcher-Transportschichten beschichteten leitfähigen transparenten (ITO) Träger, zusammen mit einem lumineszierenden Stoff, vorzugsweise mit AlQ₃, im Hochvakuum auf, z.B. durch Co-Verdampfung.
Den so erhaltenen Schichtverband versieht man gegebenenfalls mit weiteren Schichten, wie mit einer Elektronen-Transportschicht. Anschließend wird durch Verdampfung von insbesondere Li-Benzoat und Al die Metallkatode aufgebracht.

In der Zeichnung zeigen
- Fig. 1:: Einfacher Schichtenaufbau einer elektrolumineszierenden Vorrichtung
- Fig. 2:: Schichtenaufbau mit zusätzlicher Elektronen-Transportschicht
- Fig. 3:: Schichtenaufbau mit zusätzlicher Löcher-Transportschicht
- Fig. 4:: Schichtenaufbau mit zusätzlicher Löcher-Injektionsschicht

In der Zeichnung zeigt U die angelegte Spannung zwischen den entsprechenden Elektroden an.

Im einzelnen erfolgt die Herstellung in der Weise, daß man für die erfindungsgemäß zu verwendende Vorrichtung zunächst die Anode als eine transparente leitfähige Schicht von Indium-Zinn-Oxid (ITO) in einer Schichtdicke von 10 nm bis 200 nm auf einen stabilen Glasträger aufbringt. Unmittelbar vor dem Aufbringen der organischen Schichten ist diese ITO-Schicht, insbesondere nach längerer Lagerung, in einem Ultraschallbad nacheinander mit reinem Aceton und Methanol zu behandeln. Nach dem Abblasen von unlöslichen Partikeln mit einem Strahl aus verdampfbaren CO₂-Eiskristallen wird die Schicht abschließend noch mit einem Sauerstoff-Plasma behandelt, wobei organische Verunreinigungen verbrannt und abgeführt werden.

Ebenfalls nach dem Stand der Technik kann man die Löcher-Transportschicht **3** (HTL) mittels der Spin-Coating-Technik herstellen. Die Löcher-Transportschicht **3** besteht z.B. aus einer molekularen Dispersion von N,N'-diphenyl-N,N'-bis-(3-methylphenyl)-1,1'-biphenyl-4,4'-diamin (TPD) in Poly-(N-vinylcarbazol) (PVK) oder einem geeigneten Polycarbonat im Gewichtsverhältnis 1:1, wobei das Verhältnis Löcher-Transportmaterial zu löchertransportierendem Bindemittel oder auch zu einem isolierenden Bindemittel, wie zum Beispiel Polycarbonat, in weiten Grenzen variiert werden kann. Man stellt zunächst eine klare Lösung aus PVK / TPD in einem organischen Lösungsmittel oder Lösungsmittelgemisch, wie zum Beispiel in Methylenchlorid, nach allgemein bekannten Prozeduren in einem Lösegefäß unter Rühren und Inertgas bei Raumtemperatur her und beschichtet anschließend das elektrisch leitfähige transparente Substrat mittels einer Spincoating-Vorrichtung, dahingehend, daß die Löcher-Transportschicht **3** nach dem Trocknen bei 25°C bis 40°C unter Inertgas zum Beispiel in einem Vakuumtrockenschrank eine Trockenschichtdicke von 50 bis 80 nm besitzt. Es sei erwähnt, daß die Löcher-Transportschicht **3** nach dem Stand der Technik, bestehend bevorzugt aus N,N'-diphenyl-N,N'-bis-(3-methylphenyl)-1,1'-biphenyl-4,4'-diamin (TPD) oder N,N'-Biphenyl-N,N'-bis-(1-naphthyl)-benzidin (1-NPB) , auch auf den leitfähigen Träger aufgedampft werden kann.

Anschließend bringt man im Hochvakuum auf diese Schicht einen erfindungsgemäßen Farbstoff als lumineszierende Verbindung allein oder als Dotierstoff, einzeln oder auch als Gemisch mit andersartigen Dotierstoffen mittels Co-Aufdampftechnik gemeinsam mit der lumineszierenden Verbindung, zum Beispiel gemeinsam mit AlQ₃, auf. Dabei kann die Konzentration des Dotierstoffs oder auch eines Dotierstoffgemischs ,bezogen auf das Gewicht der lumineszierenden Verbindung AlQ₃, im Konzentrationsbereich zwischen 1 Gew.% und 8 Gew.% liegen, insbesondere 1,5 Gew.% bis 3 Gew.% betragen.

Die Konzentration des andersartigen Dotierstoffs im Falle der Verwendung eines Gemischs von Dotierstoffen kann dabei, je nach Verwendungszweck der elektrolumineszierenden Vorrichtung, im weiten Bereich, zum Beispiel zwischen 0,1 Gew.% und 50 Gew.%, bezogen auf das Gesamtgewicht aller Dotierstoffe, variiert werden.
Ohne Zwischenbelüftung dampft man schließlich die Metall-Kathode **1** durch Co-Verdampfung von Mg / Ag, meist im Verhältnis von 10:1 auf, vorzugsweise aber durch Verdampfung von Li-Benzoat und Al (0,7 nm Li-Benzoat plus 100 nm Al). Es können aber auch andere Metalle, wie Silber, Magnesium, Calcium oder Indium oder Legierungen hieraus oder andere Verhältnisse der Metalle oder Legierungen verwendet werden.

Sehr effiziente rot elektrolumineszierende Vorrichtungen erhält man, wenn in der lumineszierenden Schicht **2** bevorzugt die in Tabelle I aufgeführten Verbindungen **1** bis **6** als neue, für diesen Zweck bisher nicht bekannte Dotierstoffe, einzeln oder auch im Gemisch zur Dotierung von AlQ₃ verwendet werden (das Mengenverhältnis gleichartiger Dotierstoffe ist dabei frei wählbar):

Sehr effiziente rot elektrolumineszierende Vorrichtungen erhält man außerdem, wenn zur Herstellung der lumineszierenden Schicht die neuen Dotierstoffe oder auch Gemische dieser mit einem andersartigen Dotierstoff (zum Beispiel Farbstoffe nach US-A- 4,769,292), wie mit einem 1,2- oder 1,3-substituierten Quadratsäurefarbstoff, co-verdampft werden.

Das Syntheseverfahren zur Herstellung der erfindungsgemäß insbesondere als Dotierstoffe für lumineszierende Verbindungen anzuwendenden Farbstoffe ist als solches lange bekannt und von Lemke umfassend referiert worden. (Lemke, R.: Chem. Ber. **103,** 1970, 1894 - 1899; Lemke, R.: DE-A-2,345,189, Lemke R.: Synthesis **1974,** 359 - 361).

Die für die neuen Farbstoffe oder Dotierstoffe der Struktur I oder II notwendigen Ausgangsstoffe, wie zum Beispiel das 1-Oxajulolidin, im Fall der Synthese der Farbstoffe **7, 8, 11, 19, 20** gemäß der folgenden Tabelle 1, stellt man aus 8-Hydroxychinolin, Monochloressigsäure unter reduktiven Bedingungen in THF mittels Natriumborhydrid nach H. Katayama, M. Ohkoshi: Synthesis 1982, 692 - 693 her. Die Synthese der entsprechenden 9-Formyl-1-oxajulolidine erfolgt anschließend nach bekannten Formylierungsprozeduren (Organikum, Organisch-Chemisches Grundpraktikum 13. Auflage, VEB Deutscher Verlag der Wissenschaften, Berlin 1974).

Das Verfahren zur Herstellung von 9-Formyl-1,7-Dithiojulolidin ist ebenfalls bekannt und in der US-A-3,511,831 offenbart.

Heteroverbrückte 1-Methyl-vinylketone, wie das 5-Methyl-2H-pyran-3(6H)-on, stellt man nach K. Skinnemoen, K. Undheim: Acta Chemica Scandinavica B 34, 1980, 295-297 durch einen zweistufigen Prozeß aus Di-(2-propynyl)-ether über die Reaktionsstufe Diacetonyl-ether und anschließendem intramolekularen Ringschluß her.

Das entsprechende 5-Methyl-2H-thiopyran-3(6H)-on gewinnt man analog aus Diacetonyl-thioether durch intramolekularen Ringschluß.

Bevorzugte Farbstoffe der vorliegenden Erfindung sind die in der folgenden Tabelle 1 aufgeführten Verbindungen. Davon sind einige Farbstoffe, wie zum Beispiel der Farbstoff 1, bereits für die nichtlineare optische Anwendung (NLO) bekannt und in der DE 68919989 T2 offenbart. Die Erzeugung sehr hoher elektrischer Feldstärken durch Delokalisierung von Elektronen in atomaren Dimensionen, wie zum Beispiel allgemein bei Lasern angewendet, bewirkt nichtlineare Polarisationsvektoren und Suszeptibilitätstensoren in der hyperpolarisierten Verbindung, die bei Laserbestrahlung der optischen Vorrichtung zur Erzeugung neuer (höherer) Frequenzen in Absorption und Reflexion führt (Frequenzverdopplung, Summen- und Differenzfrequenzen) und in verschiedenen Effekten und Anwendungen ausgenutzt werden kann (Pockels-Effekt, Kohärente Anti-Stokes-Ramanstreuung, Zweiphotonen-Absorptions- und Emissions-Spektroskopie; optischer Kerr-Effekt für optische Schalter u.ä.).

Da es bei diesen NLO-Anwendungen jedoch in erster Linie um Absorptioneigenschaften geht und Fluoreszenzeigenschaften nicht berührt werden, ist der Einsatz auch dieser bekannten Verbindungen für Emissionsanwendungen wie in organischen lichtemittierenden Vorrichtungen nicht naheliegend.

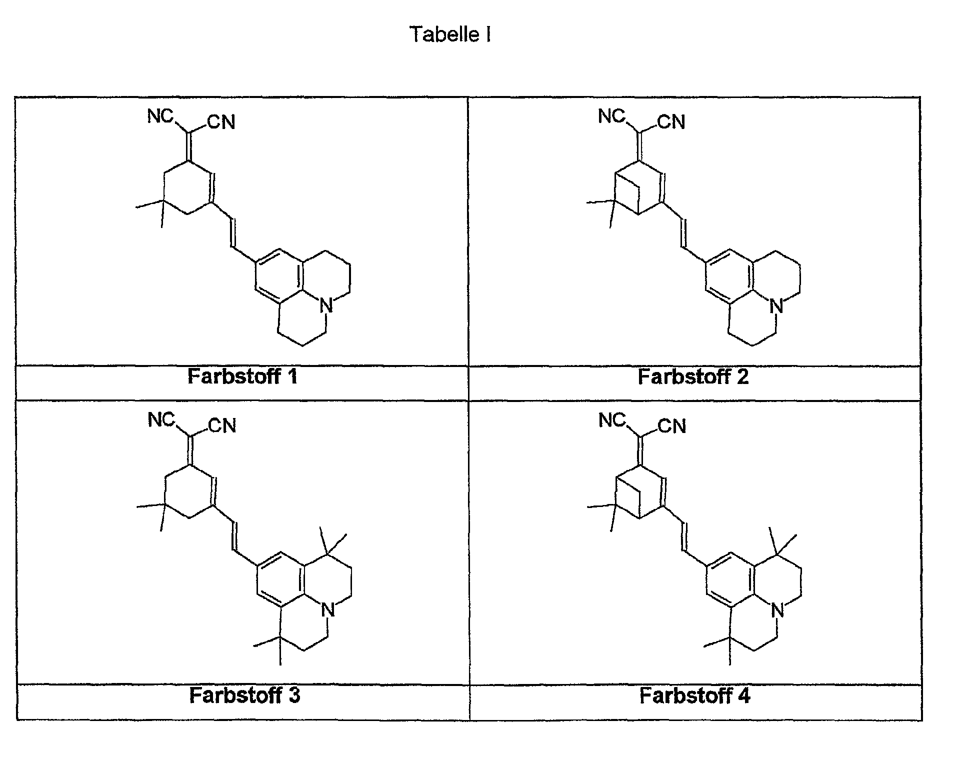

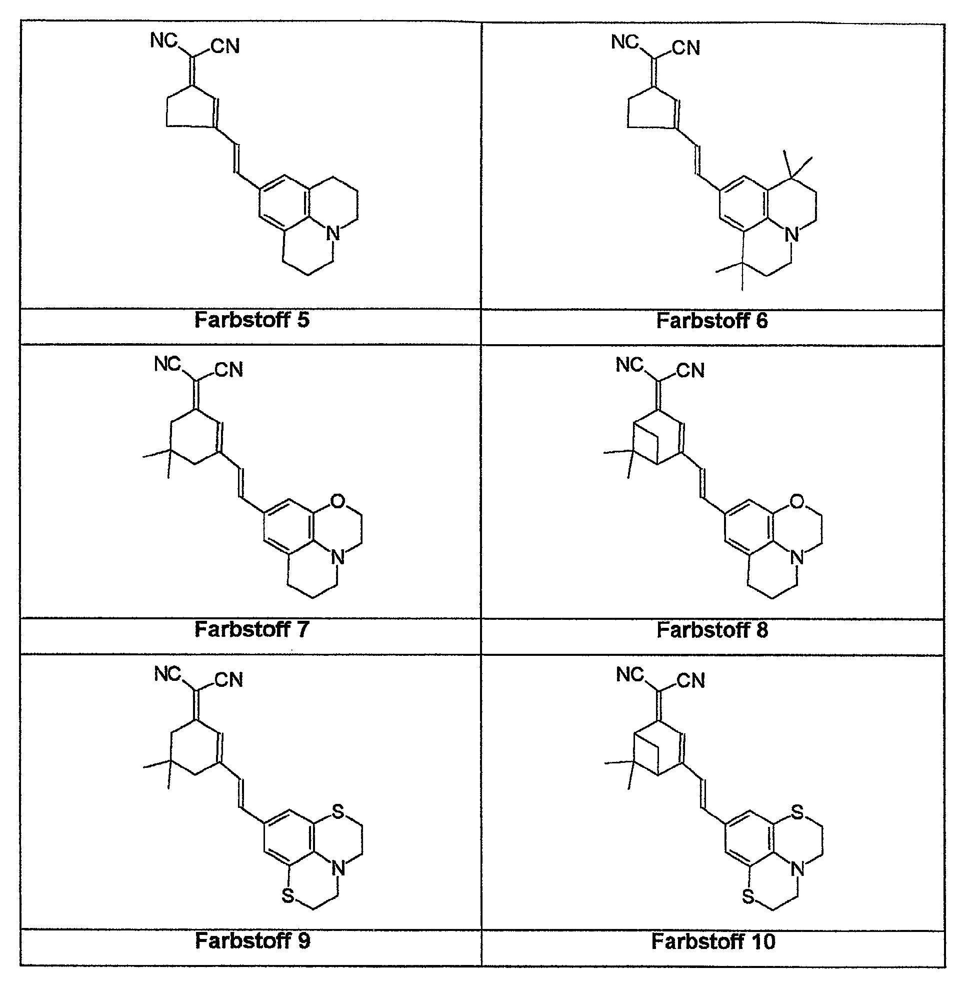

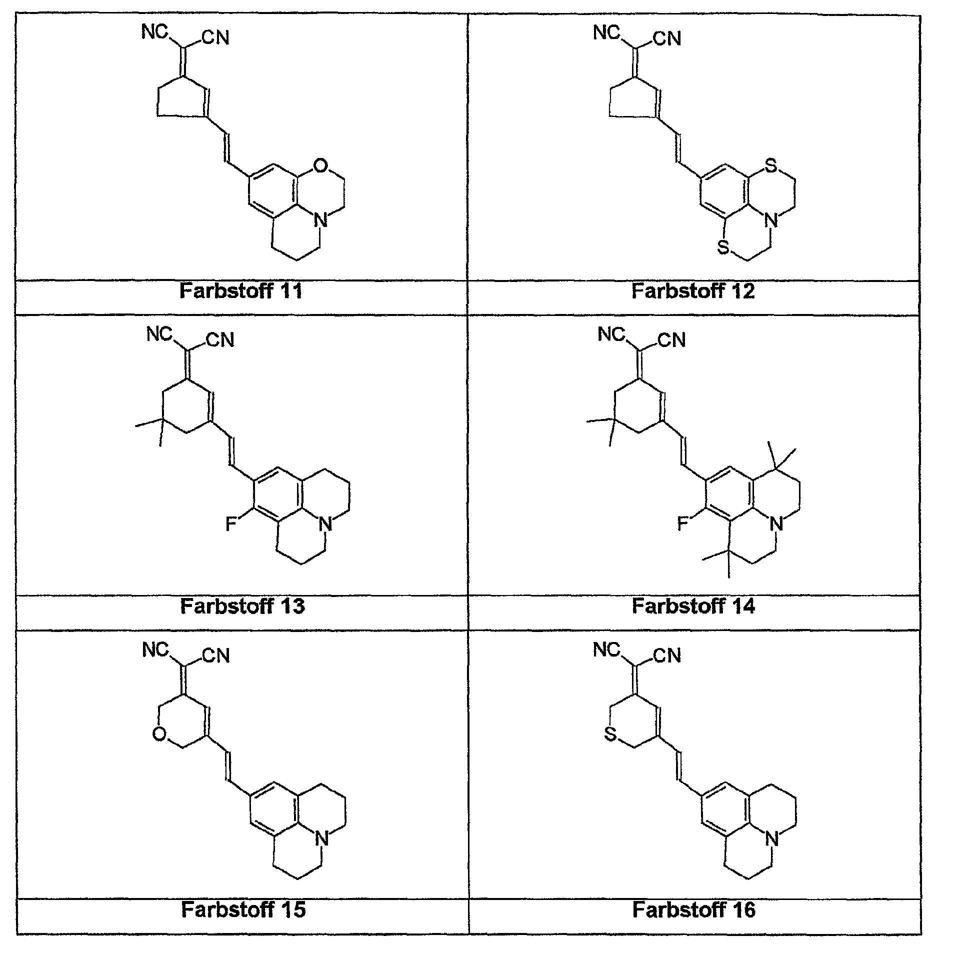

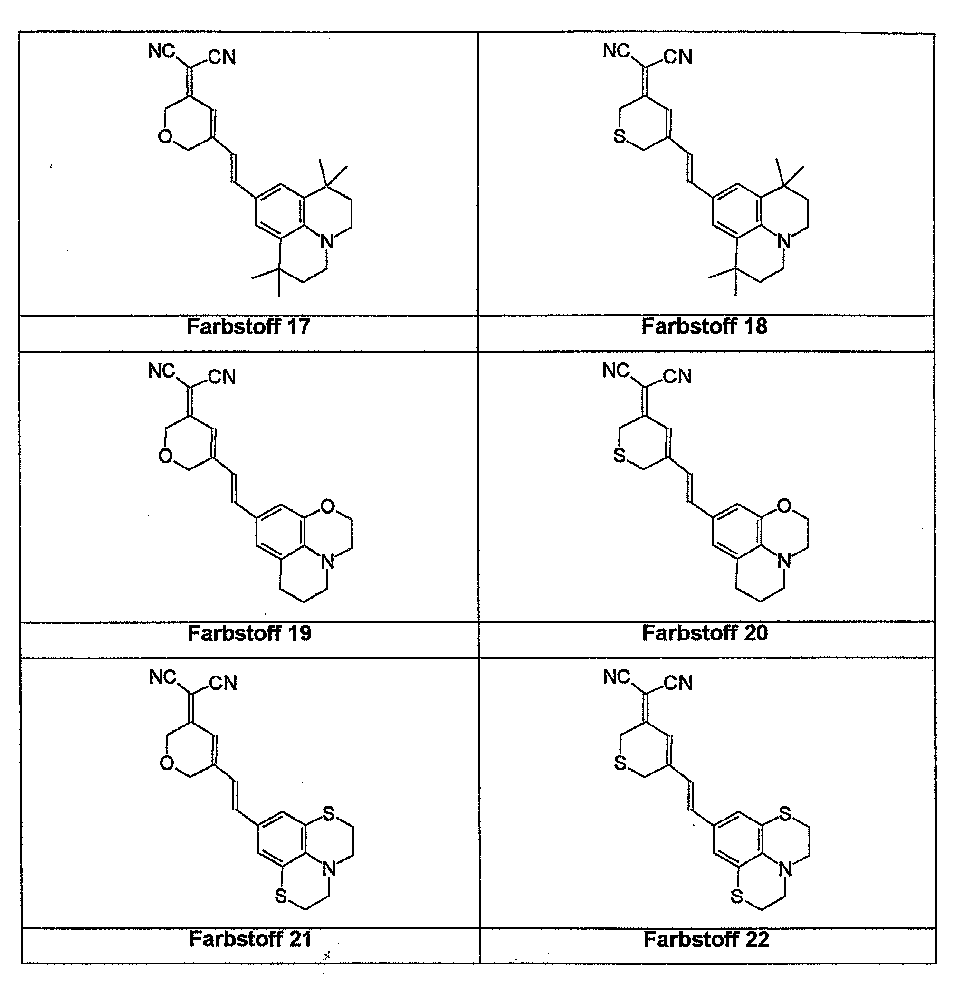

Die folgenden Beispiele sollen der näheren Erläuterung der Erfindung dienen, wobei die Erfindung nicht nur auf diese beschränkt ist.

Beispiel 1 (allgemeines Synthesebeispiel) Zur Herstellung der erfindungsgemäß zu verwendenden Farbstoffe werden 11 mmol eines cyclischen 1-Methyl-vinylketons (Isophoron, Verbenon, 5-Methyl-2H-pyran-3(6H)-on, 5-Methyl-2H-thiopyran-3(6H)-on u.ä.) 0,66 g (10 mmol) Malonitril und 0,15 g Piperidin in 10 ml Dimethylformamid in einem 50 ml Dreihalskolben, versehen mit Thermometer und Magnetrührer vorgelegt und zunächst 1 Stunde bei 25°C unter Rühren erwärmt. Danach erhitzt man eine weitere Stunde bei einer Temperatur von 80°C. Die Reaktionsmischung färbt sich dabei stärker braun. Nun gibt man in mehreren Portionen 10 mmol des entsprechenden 9-Formyljulolidins, wie des 9-Formyl-8-Fluor-1,1,7,7-tetramethyljulolidins, des 9-Formyl-1,7-Dithiojulolidins oder des 9-Formyl-1-Oxajulolidins, als Feststoff oder auch in Lösung unter Rühren zur heißen Reaktionsmischung hinzu und erhitzt erneut 1 Stunde bei 80°C. Die Farbe der Reaktionsmischung verändert sich nach tief rotviolett. Der Reaktionsfortgang wird dünnschichtchromatographisch verfolgt (Kieselgel 60, Laufmittelgemisch: 1-Butanol / Ethanol / Essigsäure / Wasser 60 / 10 / 5 / 20). Nachdem sich der jeweilige Farbstoff in gewünschter Menge gebildet hat, wird die Reaktion abgebrochen. Nach dem Erkalten und Stehen über Nacht wird das Kristallisat abgesaugt, mehrmals zur Entfernung von nicht reagiertem Ausgangsmaterial mit Methanol gewaschen und bei 60°C in einem Vakuumtrockenschrank 8 Stunden getrocknet. Farbstoffe, die nicht gleich kristallisieren, werden durch Versetzen der Reaktionslösung mit einem Fällungsmittel, wie zum Beispiel mit Methanol, zur Kristallisation gebracht.
Die Reinigung der Farbstoffe erfolgt allgemein durch Umkristallisation, wie zum Beispiel aus Methanol und anschließender Sublimation im Hochvakuum.

### Beispiel 2

Auf einen mit ITO (Indium-Zinn-Oxid) **4** beschichteten Glasträger **5** wurde gemäß der **Fig. 1** eine Löcher-Transportschicht (HTL) 3 durch Spin-Coating einer Lösung von N,N'diphenyl-N,N'-bis-(3-methylphenyl)-benzidin im Gemisch mit Poly-(N-vinylcarbazol) 1:1 (Gewichtsteile) in Dichlormethan aufgetragen. Nach dem Trocknen der Schicht unter Inertgas bei einer Temperatur zwischen 25°C und 40°C beträgt die Schichtdicke 50 nm. Man bringt nun auf die so erhaltene Löcher-Transportschicht **3** im Hochvakuum (10⁻⁵hPa) die Elektrolumineszenzschicht **2** durch Co-Verdampfung von AlQ₃ und dem gereinigten **Farbstoff 1** in einer Konzentration von 1,5 Gew.%, bezogen auf AlQ₃, auf. Anschließend wird durch Verdampfung von LiF und Al (0,7 nm Li-Fluorid + 100 nm Al) die Metall-Kathode **1** aufgebracht. Die Verfahrensweise für die Metallkatode kann sinngemäß auch entsprechend Beispiel 3 erfolgen.

Zur Messung der Elektrolumineszenz wurde zwischen die ITO- und Metallelektrode eine regelbare Spannung zwischen 1 und 20 V angelegt. Die so erhaltene Vorrichtung zeigt eine Leuchtdichte bis zu 580 cd/m² bei 12,6 V. Das emittierte Licht ist frei von Nebenemissionen des AlQ₃ im Bereich um 530 nm und zeigt visuell einen sehr reinen roten Farbton.

### Beispiel 3

Auf einen mit ITO (Indium-Zinn-Oxid) **4** beschichteten Glasträger **5** wurde gemäß der **Fig. 1** eine Löcher-Transportschicht (HTL) **3** aus N,N'-diphenyl-N,N'-bis-(3-methylphenyl)-benzidin in einer Schichtdicke von 50 nm im Hochvakuum (10⁻⁵hPa) aufgedampft. Man bringt nun auf die so erhaltene Loch-Transportschicht **3** die Elektrolumineszenzschicht **2** durch Co-Verdampfung von AlQ₃ und dem gereinigten **Farbstoff 1** in einer Konzentration von 2 Gew.%, bezogen auf AlQ₃ ,auf. Die Dicke der aufgedampften Elektrolumineszenzschicht **2** beträgt 60 nm. Anschließend wird durch Verdampfung von Li-Benzoat und Al (0,7 nm Li-Benzoat + 100 nm Al) die Metall-Kathode **1** aufgebracht.

Zur Messung der Elektrolumineszenz wurde zwischen die ITO- und Metallelektrode eine regelbare Spannung zwischen 1 und 20 V angelegt. Die so erhaltene Vorrichtung zeigt eine Leuchtdichte bis zu 600 cd/m² bei 12,8 V. Das emittierte Licht ist frei von Nebenemissionen des AlQ₃ im Bereich um 530 nm und zeigt visuell einen sehr reinen roten Farbton.

### Beispiel 4

Auf einen mit ITO (Indium-Zinn-Oxid) **4** beschichteten gereinigten Glasträger **5** wird gemäß der **Fig. 2** eine Löcher-Transportschicht (HTL) 3 aus 4,4',4"- Tris-(N-(1-naphthyl)-N-phenyl-amino)-triphenylamin in einer Schichtdicke von 55 nm im Hochvakuum (10⁻⁵hPa) aufgedampft. Man bringt nun auf die so erhaltene Löcher-Transportschicht **3** die lumineszierenden Schicht **2** durch Co-Verdampfung von AlQ₃ und dem gereinigten **Farbstoff 1** in einer Konzentration von 1,5 Gew.%, bezogen auf AlQ₃, auf. Die Dicke der aufgedampften lumineszierenden Schicht **2** beträgt 30 nm. Auf diese Schicht dampft man nun 10 nm AlQ₃ als Elektronentransportschicht **6** auf. Anschließend wird durch Verdampfung von LiF und Al (0,7 nm LiF + 100 nm AL) die Metall-Kathode **1** aufgebracht. Die Verfahrensweise für die Metallkatode kann sinngemäß auch entsprechend Beispiel 3 erfolgen.

Zur Messung der Elektrolumineszenz wird zwischen die ITO- und Metallelektrode eine regelbare Spannung zwischen 1 und 15 V angelegt. Die so erhaltene Vorrichtung zeigt eine Leuchtdichte bis zu 900 cd/m² bei 14 V. Das emittierte Licht ist frei von Nebenemissionen des AlQ₃ im Bereich um 530 nm und zeigt visuell einen sehr reinen roten Farbton.

### Beispiel 5

Auf einen mit ITO (Indium-Zinn-Oxid) **4** beschichteten gereinigten Glasträger **5** werden eine 5 nm dicke Löcher-Injektionsschicht aus CuPC, eine Löcher-Transportschicht (HTL) **3b** aus 4,4',4"- Tris-(N-(1-naphthyl)-N-phenyl-amino)-triphenylamin in einer Schichtdicke von 55 nm und eine weitere Löcher-Transportschicht **3a** aus N,N'-Biphenyl-N,N'-bis-(1-naphthyl)-benzidin (1-NPB) in einer Schichtdicke von 5 nm im Hochvakuum (10⁻⁵hPa) nacheinander aufgedampft. Man bringt nun auf die so erhaltenen Löcher-Transportschichten **3a, 3b** die lumineszierenden Schicht **2** durch Co-Verdampfung von AlQ₃ und dem gereinigten **Farbstoff 1** in einer Konzentration von 2 Gew.%, bezogen auf AlQ₃, auf. Die Dicke der aufgedampften lumineszierenden Schicht **2** beträgt 40 nm. Auf diese Schicht dampft man nun 5 nm AlQ₃ als Elektronentransportschicht **6** auf. Anschließend wird durch Verdampfung von Li-Benzoat und Al (0,7 nm Li-Benzoat + 100 nm Al) die Metall-Kathode **1** aufgebracht.

Zur Messung der Elektrolumineszenz wird zwischen die ITO- und Metallelektrode eine regelbare Spannung zwischen 1 und 15 V angelegt. Die so erhaltene Vorrichtung zeigt eine Leuchtdichte bis zu 2050 cd/m² bei 14,0 V. Das emittierte Licht ist frei von Nebenemissionen des AlQ₃ im Bereich um 530 nm und zeigt visuell einen sehr reinen roten Farbton.

### Beispiel 6

Bringt man nun analog dem Schichtaufbau des Beispiels 5 auf die Löchertransportschichten **3a, 3b** die lumineszierende Schicht **2** durch Co-Verdampfung von AlQ₃ und **Farbstoff 1** auf, wobei dieser in einer Konzentration von nur 0,7 Gew.% (Unterdotierung) bezogen auf AlQ₃ angewendet wird, so erhält man eine elektrolumineszierende Vorrichtung, die bei einer zwischen ITO- und Metallelektrode angelegten Spannung von 17 V alternativ weißes Licht emittiert.

### Beispiel 7

Auf einen mit ITO (Indium-Zinn-Oxid) **4** beschichteten gereinigten Glasträger **5** werden eine 5 nm dicke Löcher-Injektionsschicht aus CuPC, eine Löcher-Transportschicht (HTL) **3b** aus 4,4',4"- Tris-(N-(1-naphthyl)-N-phenyl-amino)-triphenylamin in einer Schichtdicke von 55 nm und eine weitere Löcher-Transportschicht **3a** aus N,N'-Biphenyl-N,N'-bis-(1-naphthyl)-benzidin (1-NPB) in einer Schichtdicke von 5 nm im Hochvakuum (10⁻⁵hPa) nacheinander aufgedampft. Man bringt nun auf die so erhaltenen Löcher-Transportschichten **3a, 3b** die lumineszierenden Schicht **2** durch Co-Verdampfung von AlQ₃ und dem gereinigten **Farbstoff 14** in einer Konzentration von 2,5 Gew.%, bezogen auf AlQ₃, auf. Die Dicke der aufgedampften lumineszierenden Schicht **2** beträgt 40 nm. Auf diese Schicht dampft man nun 5 nm AlQ₃ als Elektronentransportschicht **6** auf. Anschließend wird durch Verdampfung von Li-Benzoat und Al (0,7 nm Li-Benzoat + 100 nm Al) die Metall-Kathode **1** aufgebracht.

Zur Messung der Elektrolumineszenz wird zwischen die ITO- und Metallelektrode eine regelbare Spannung zwischen 1 und 15 V angelegt. Die so erhaltene Vorrichtung zeigt eine Leuchtdichte bis zu 2000 cd/m² bei 13,8 V. Das emittierte Licht ist frei von Nebenemissionen des AlQ₃ im Bereich um 530 nm und zeigt visuell einen sehr reinen roten Farbton.

### Beispiel 8

Bringt man nun analog dem Schichtaufbau des Beispiels 7 auf die Löchertransportschichten **3a, 3b** die lumineszierende Schicht **2** durch Co-Verdampfung von AlQ₃ und Farbstoff **14** auf, wobei dieser in einer Konzentration von nur 0,6 Gew.% (Unterdotierung) bezogen auf AlQ₃ angewendet wird, so erhält man eine elektrolumineszierende Vorrichtung, die bei einer zwischen ITO- und Metallelektrode angelegten Spannung von 17 V alternativ weißes Licht emittiert.

## Patentansprüche

1. Elektrolumineszierende Vorrichtung, bestehend aus einer Löcher-Transportschicht und einer lumineszierenden Schicht zwischen zwei leitfähigen Elektroden, wobei wenigstens eine Elektrode transparent ist,
**dadurch gekennzeichnet, daß**
die lumineszierende Schicht als lumineszierende Verbindung oder als Dotierstoff für eine lumineszierende Verbindung wenigstens eine Verbindung der allgemeinen Formel I enthält 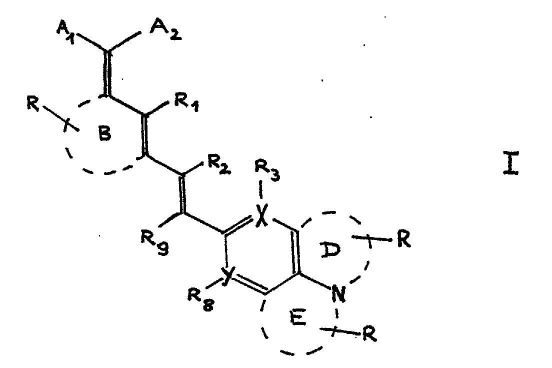 worin
B ein ungesättigter carbocyclischer oder heterocyclischer 4-8-gliedriger Ring mit O, N oder S als Heteroatom ist, wobei im Falle eines 6-8-gliedrigen Ringes zwei C-Atome verbrückt sein können;
die Ringe D und E sind fünf- oder sechsgliedrige Ringe, die jeweils ein weiteres Heteroatom enthalten können, ausgewählt unter N, O und S;
die Reste R sind ein oder mehrere Substituenten, die gleich oder verschieden sein können und Wasserstoff oder geradkettiges oder verzweigtes C₁-C₆-Alkyl sind;
X und Y können Kohlenstoff oder Stickstoff sein;
R₁, R₂ und R₉ sind gleich oder verschieden und sind Wasserstoff oder geradkettiges oder verzweigtes C₁-C₆-Alkyl;
R₃ und R₈ sind gleich oder verschieden und sind Wasserstoff, geradkettiges oder verzweigtes C₁-C₆-Alkyl, Hydroxy, -OR₁₆, -COOR₁₆, N,N-Dialkylamino, Acetylamino oder Halogen, wobei R₁₆ Wasserstoff, oder geradkettiges oder verzweigtes C₁-C₆-Alkyl ist,
R₁ und R₂ oder R₂ und R₃ und/oder R₈ und R₉ können zusammen einen alicyclischen, heterocyclischen oder aromatischen Ring bilden; und
A₁ und A₂, die gleich oder verschieden sein können, sind Cyan, Nitro oder -COOR₁₆, wobei R₁₆ Wasserstoff oder geradkettiges oder verzweigtes C₁-C₆-Alkyl ist.

2. Elektrolumineszierende Vorrichtung nach Anspruch 1, **dadurch gekennzeichnet, daß** sie als Dotierstoff für elektrolumineszierende Verbindungen eine Verbindung der allgemeinen Formel II enthält, 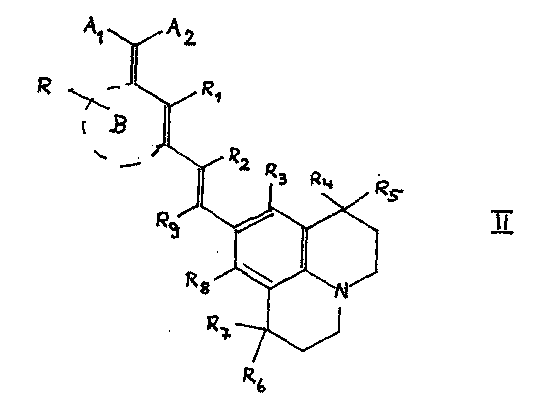 worin R₁, R₂, R₄ bis R₇ und R₉ gleich oder verschieden sind und Wasserstoff, oder geradkettiges oder verzweigtes C₁-C₆-Alkyl darstellen,
R₃ und R₈ sind gleich oder verschieden und sind Wasserstoff, geradkettiges oder verzweigtes C₁-C₆-Alkyl, Hydroxy, -OR₁₆,
-COOR₁₆, N,N-Dialkylamino, Acetylamino oder Halogen, wobei R₁₆ Wasserstoff, oder geradkettiges oder verzweigtes C₁-C₆-Alkyl ist,
R₁ und R₂ oder R₂ und R₃ und/oder R₈ und R₉ können zusammen einen alicyclischen, heterocyclischen oder aromatischen Ring bilden,
B ist ein fünf- oder sechsgliedriger ungesättigter Ring, bei dem im Falle eines sechsgliedrigen Ringes zwei Ringatome in 1,3-Stellung zueinander eine alicyclische Brücke bilden können, und die Reste R sind ein oder mehrere Substituenten, die gleich oder verschieden sein können und Wasserstoff oder geradkettiges oder verzweigtes C₁-C₆-Alkyl sind;
A₁ und A₂, die gleich oder verschieden sein können, sind Cyan, Nitro oder -COOR₁₆, wobei R₁₆ Wasserstoff oder geradkettiges oder verzweigtes C₁-C₆-Alkyl ist.

3. Elektrolumineszierende Vorrichtung nach Anspruch 1 oder 2, **dadurch gekennzeichnet, daß** die Reste R bis R₉ in der Bedeutung C₁-C₆-Alkyl jeweils Methyl, Isopropyl oder tert-Butyl darstellen.

4. Elektrolumineszierende Vorrichtung nach ein Anspruch 1 oder 2, **dadurch gekennzeichnet, daß** die Verbindung der Formel I als Dotierstoff im Gemisch mit anderen Dotierstoffen vorliegt, ausgewählt aus der Gruppe, bestehend aus 2-Alkyl-6-N,N-dialkylaminostyryl- oder Julolidin-substitituierten 4-Dicyanomethylen-4-H-pyranen, entsprechenden mit tert-Butyl am Pyranring substituierten Pyranen und 3-(Dixyanomethylen)-5,5-dimethyl-1-(4-N,N-dimethylamino-styryl)cyclohexan, insbesondere mit einem 1,2- oder 1-3-substituierten Quadratsäure-Farbstoff.

5. Elektrolumineszierende Vorrichtung nach Anspruch 1 oder 2, **dadurch gekennzeichnet, daß** die organische lumineszierende Verbindung ausgewählt ist unter Tris-(8-hydoxychinolino)-aluminium (AlQ₃), Derivaten des 1,3,4-Oxadiazols und Distyryl-aryl-Derivaten.

6. Elektrolumineszierende Vorrichtung nach Anspruch 1 oder 2, **dadurch gekennzeichnet, daß** die Konzentration des Dotierstoffes der Formel I im Bereich von >1 Gew-% bis 8 Gew-% liegt, insbesondere im Bereich von 1,5 bis 3 Gew-%, bezogen auf das Gewicht der lumineszierenden Verbindung AlQ₃.

7. Elektrolumineszierende Vorrichtung nach Anspruch 6, **dadurch gekennzeichnet, daß** sie zusammen mit AlQ₃ eine reine rote Lichtemission erzeugt.

8. Elektrolumineszierende Vorrichtung nach Anspruch 7, **dadurch gekennzeichnet, daß** sie Leuchtdichten aufweist, die im Bereich von 580-2050 cd/m² bei 10-12 V liegen und rotes Licht ohne Nebenemission von AlQ₃ bei 530 nm emittiert.

9. Elektrolumineszierende Vorrichtung nach Anspruch 1 oder 2, **dadurch gekennzeichnet, daß** die Konzentration der Dotierstoffe im Bereich von 0,1 bis 1 Gew-% liegt, bezogen auf das Gewicht der lumineszierenden Verbindung AlQ₃, und daß sie zusammen mit AlQ₃ ein weißes Licht emittiert.

10. Verbindungen der allgemeinen Formel I 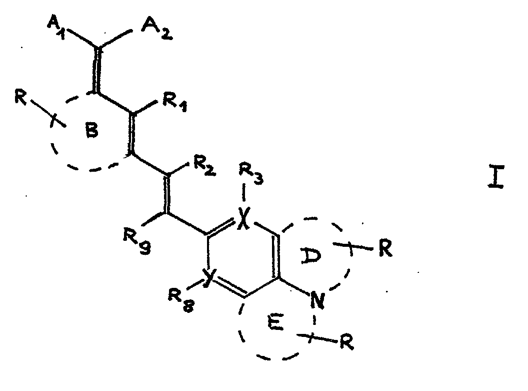 worin B ein 4-, 5-, 7-, oder 8 gliedriger ungesättigter carbocyclischer Ring ist, der durch Wasserstoff und/oder C₁-C₆-Alkyl substituiert ist und im Falle eines 5-gliedrigen Ringes wenigstens einen C₁-C₆-Alkylrest trägt; oder
B ist ein gegebenenfalls durch eine oder mehrere geradkettige oder verzweigte C₁-C₆-Alkylgruppen substituierter 6-gliedriger ungesättigter Ring, bei dem zwei Ringatome in 1,3-Stellung zueinander verbrückt sind; oder
B ist ein 6- gliedriger ungesättigter carbocyclischer Ring, der durch eine oder mehrere C₁-C₆-Alkylgruppen substituiert ist; oder
B ist ein ungesättigter heterocyclischer 4- bis 8-gliedriger Ring mit O, N oder S als Heteroatome, der weiter durch Wasserstoff und/oder eine oder mehrere C₁-C₆-Alkylgruppen substituiert ist;
und
die Ringe D und E sind fünf- oder sechsgliedrige Ringe, die jeweils ein weiteres Heteroatom enthalten können, ausgewählt unter N, O und S, mit der Maßgabe, daß wenigstens einer der beiden Ringe ein weiteres Heteroatom enthält; und
die Reste R sind ein oder mehrere Substituenten, die gleich oder verschieden sein können und Wasserstoff oder geradkettiges oder verzweigtes C₁-C₆-Alkyl sind;
X und Y können Kohlenstoff oder Stickstoff sein;
R₁, R₂ und R₉ sind gleich oder verschieden und sind Wasserstoff oder geradkettiges oder verzweigtes C₁-C₆-Alkyl;
R₃ und R₈ sind gleich oder verschieden und sind Wasserstoff, geradkettiges oder verzweigtes C₁-C₆-Alkyl, Hydroxy, -OR₁₆, -COOR₁₆, N,N-Dialkylamino, Acetylamino oder Halogen, wobei R₁₆ Wasserstoff, oder geradkettiges oder verzweigtes C₁-C₆-Alkyl ist,
R₁ und R₂ oder R₂ und R₃ und/oder R₈ und R₉ können zusammen einen alicyclischen, heterocyclischen oder aromatischen Ring bilden; und
A₁ und A₂, die gleich oder verschieden sein können, sind Cyan, Nitro oder -COOR₁₆, wobei R₁₆ Wasserstoff oder geradkettiges oder verzweigtes C₁-C₆-Alkyl ist.

11. Verbindungen der allgemeinen Formel I nach Anspruch 7, worin B ein 5-gliedriger ungesättigter carbocyclischer Ring ist und die Ringe D und E sechsgliedrige carbocyclische Ringe sind, die durch C₁-C₆-Alkylgruppen substituiert sind; oder worin
B ein gegebenenfalls durch eine oder mehrere geradkettige oder verzweigte C₁-C₆-Alkylgruppen substituierter sechsgliedriger ungesättigter carbocyclischer Ring ist, bei dem zwei Ringatome in 1,3-Stellung zueinander eine alicyclische Brücke 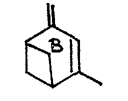 bilden
und die Ringe D und E sechsgliedrige carbocyclische Ringe sind, die durch Wasserstoff und/oder C₁-C₆-Alkylgruppen substituiert sind,
und worin X und Y Kohlenstoff sind

12. Verbindung nach einem der Ansprüche 10 oder 11, **dadurch gekennzeichnet, daß** die Reste R bis R₉ in der Bedeutung C₁-C₆-Alkyl jeweils Methyl, Isopropyl oder tert-Butyl darstellen.
